# EUROPEAN PATENT SPECIFICATION

(11) **EP 1 443 666 B1**
(45) Date of publication and mention of the grant of the patent: **02.08.2006**
(21) Application number: 04008904.7
(22) Date of filing: 01.12.1998
(51) Int. Cl.: H04B 1/40, H04B 1/52, H04B 1/48, H05K 1/02, H01P 1/15

(54) **Multiband high-frequency switching module**
Multibandhochfrequenzschaltmodul
Module de commutation multibande pour radiofréquences

(30) Priority: 03.12.1997 JP 33335897; 05.12.1997 JP 33519897; 28.04.1998 JP 11803998; 27.07.1998 JP 21120898
(43) Date of publication of application: 04.08.2004
(62) Divisional of application: 98122784.6
(73) Proprietor: HITACHI METALS, LTD., Minato-ku, Tokyo 105-8614 (JP)
(72) Inventor: Kemmochi, Shigeru, Tottori-shi Tottori-ken (JP); Watanabe, Mitsuhiro, Tottori-shi Tottori-ken (JP); Tai, Hiroyuki, Tottori-shi Tottori-ken (JP); Taketa, Tsuyoshi, Iwami-gun Tottori-ken (JP); Tanaka, Toshihiko, Tottori-shi Tottori-ken (JP)
(74) Representative: Strehl Schübel-Hopf & Partner

(56) References cited:
- EP-A- 0 567 766
- EP-A- 0 578 160
- EP-A- 0 704 925
- US-A- 5 473 293

## Description

### BACKGROUND OF THE INVENTION

The present invention relates to a high-frequency composite circuit part, more specifically, to a multiband high-frequency switching module used in a communication system utilising a plurality of transmit-receive systems having different passbands.

A digital cellular radiotelephone uses a high-frequency switch to alternately and electrically connect an antenna (ANT) to a transmitting circuit (TX) or a receiving circuit (RX).

Fig. 15 is a schematic circuit diagram showing a conventional single-band high-frequency switch circuit disclosed in JP-A-6-197040. In Fig. 15, the high-frequency switch alternately connects an antenna ANT to a transmitting circuit TX or a receiving circuit RX, and comprises a first diode D 1 the anode thereof being connected to the transmitting circuit TX and the cathode thereof being connected to the antenna ANT, a strip line SL connected between the antenna ANT and the receiving circuit RX, and a second diode D2, the anode thereof being connected between the strip line SL and the receiving circuit RX and the cathode thereof being grounded. The high-frequency switch is made into a dielectric laminate body having a plurality of substrates, in which the strip line SL is disposed on an inner substrate and the diodes D1, D2 are mounted on the top surface of the dielectric laminate body.

With the recent striking spread of the cellular radiotelephone, there has been increased demand for improving the performance thereof, expanding the service area, etc. As a radiotelephone of new type, a dual-band radiotelephone has been proposed. In contrast to the conventional radiotelephone which utilises a single transmit-receive system, the dual-band radiotelephone uses two transmit-receive systems having different passbands. A user may communicate by suitably selecting a desired transmit-receive system.

If the respective transmit-receive systems are constituted by different circuits, the resultant dual-band radiotelephone would become large in its size and expensive. Therefore, the parts for the dual-band radiotelephone, as many as possible, should be shared between the transmit-receive systems in view of reducing the size and the production cost.

EP-A-0 704 925 discloses a single-band high-frequency switching module in the form of a laminate body for use in a communication system a transmit-receive system, comprising a switching circuit connected in parallel to a receive terminal for connection to a receiving circuit and a transmit terminal for connection to a transmitting circuit so as to alternately connect an antenna to the receiving circuit and the transmitting circuit, wherein the laminate body comprises a plurality of dielectric layers, pattern electrodes printed on the dielectric layers, terminal electrodes formed on surfaces of the laminate body, and chip elements mounted on a top surface of the laminate body, and wherein a transmit system comprising the antenna terminal, the switching circuit and the transmit terminal has a low-pass filtering function provided by a low-pass filter circuit comprising an LC circuit formed in the laminate body by pattern electrodes.

EP-A-0 567 766 discloses a car antenna switch used for a single-band mobile phone. The switch has three filters connected to a common multi-region-radiator for passing high-frequency signals of a medium frequency region, of an upper frequency region, and of a lower frequency region (for a car radio).

### OBJECT AND SUMMARY OF THE INVENTION

Accordingly, an object of the present invention is to provide a multiband high-frequency switching module for alternately and electrically connecting a common antenna to a transmitting circuit or a receiving circuit of any one of two or more transmit-receive systems having different passbands.

Another object of the present invention is to provide a multiband high-frequency switching module made into a small laminated structure.

These objects are met by the multiband high-frequency switching module defined in claim 1.

### BRIEF DESCRIPTION OF THE DRAWINGS

Fig. 1 is a block schematic diagram showing a preferred embodiment of the multiband high-frequency switching module according to the present invention;
Fig. 2 is a schematic circuit diagram showing an equivalent circuit of the multiband high-frequency switching module of Fig. 1;
Fig. 3 is a plan view of a laminate body of the multiband high-frequency switching module according to the present invention;
Fig. 4 is a perspective view of a laminate body of the multiband high-frequency switching module according to the present invention;
Fig. 5 is a plan view showing each substrate constructing the laminate body of Figs. 3 and 4;
Fig. 6 is a block schematic diagram showing a first preferred circuit of the multiband high-frequency switching module according to the present invention;
Fig. 7 is a block schematic diagram showing a second preferred circuit of the multiband high-frequency switching module according to the present invention;
Fig. 8 is a block schematic diagram showing a third preferred circuit of the multiband high-frequency switching module according to the present invention;
Fig. 9 is a block schematic diagram showing a fourth preferred circuit of the multiband high-frequency switching module according to the present invention;
Fig. 10 is a block schematic diagram showing a fifth preferred circuit of the multiband high-frequency switching module according to the present invention;
Fig. 11 is a block schematic diagram showing a sixth preferred circuit of the multiband high-frequency switching module according to the present invention;

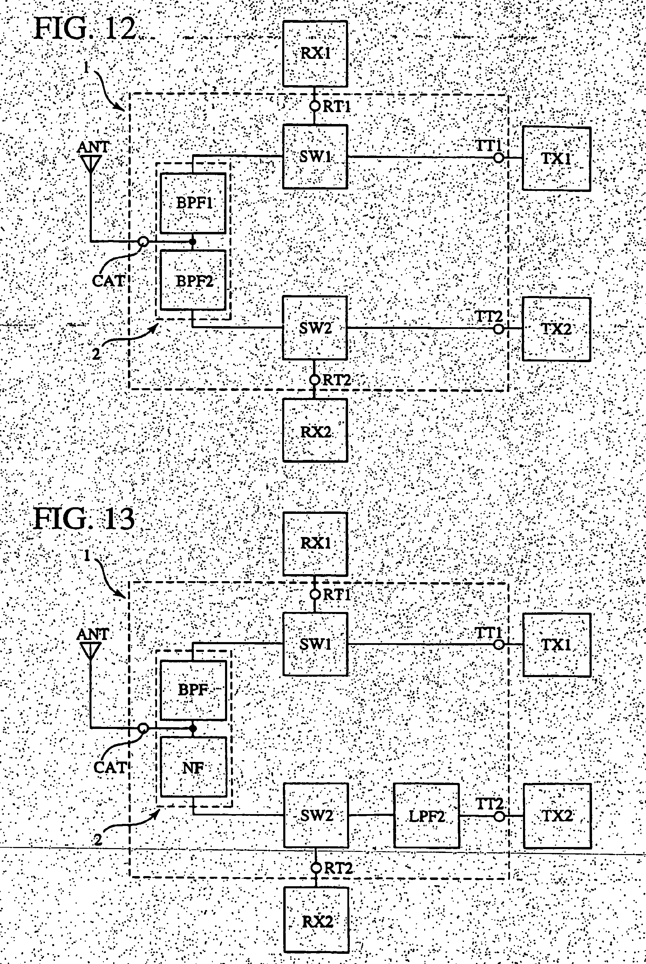

Fig. 12 is a block schematic diagram showing a multiband high-frequency switching module which is not an embodiment of the present invention;
Fig. 13 is a block schematic diagram showing a seventh preferred circuit of the multiband high-frequency switching module according to the present invention;
Fig. 14 is a block schematic diagram showing an eighth preferred circuit of the multiband high-frequency switching module according to the present invention; and
Fig. 15 is a schematic circuit diagram showing a conventional single-band high-frequency switch circuit.

### DESCRIPTION OF THE PREFERRED EMBODIMENTS

The multiband high-frequency switching module of the present invention comprises a band-separating circuit, switching circuits each alternately connecting a common antenna to a receiving circuit or a transmitting circuit of any one of a plurality of transmit-receive systems having different passbands, and terminals for connecting the common antenna, the receiving circuit, or the transmitting circuit.

The present invention will be described while taking a high-frequency switching module for a dual-band system as an example. However, it should be noted that the present invention is equally applicable to a communication system including three or more transmit-receive systems having different passbands, regardless of the following description of preferred embodiments.

In a preferred embodiment of the present invention, the multiband high-frequency switching module may comprise a band-separating circuit, a first switching circuit for a first transmit-receive system and a second switching circuit for a second transmit-receive system. Such a multiband high-frequency switching module is suitable for use in an dual-band cellular radiotelephone.

The band-separating circuit separates a communication signal into two bands for the first and second transmit-receive systems. The band-separating circuit is constituted by two filter circuits, each comprising an inductor component and a capacitor component and corresponding to each of the first and second transmit-receive systems. The circuits for the band-separating circuit may be notch filter circuits, low-pass filter circuits, high-pass filter circuits, band-pass filter circuits, or any combination of these circuits. For example, the band-separating circuit may be constituted by first and second notch filter circuits, each comprising parallel-connected inductor and capacitor. One end of each notch filter circuit is respectively connected to the corresponding switching circuit, and the other end thereof is connected to a common antenna terminal for connecting the common antenna. Between one of the notch filter circuits and its corresponding switching circuit, a capacitor being grounded may be connected in a shunt configuration. Between the other notch filter circuit and its corresponding switching circuit, a capacitor may be connected and an inductor being grounded may be further connected in a shunt configuration between the notch filter circuit and the capacitor.

Each of the first and second transmit-receive systems includes one switching circuit, one end thereof being connected to the band-separating circuit which is connected to the common antenna terminal for connecting the common antenna terminal, another end thereof being connected to a receive terminal for connecting the receiving circuit, and still another end thereof being connected to a transmit terminal for connecting the transmitting circuit. Thus, the first switching circuit alternately connects the common antenna to a first transmitting circuit or a first receiving circuit, and the second switching circuit alternately connects the common antenna to a second transmitting circuit or a second receiving circuit.

The switching circuit may be a diode switching circuit which is connected to a control circuit through a control terminal to apply a voltage of a predetermined level to the diodes, thereby controlling the switching operation. For example, the multiband high-frequency switching module may have first and second control terminals for controlling the transmitting circuits of the first and second transmit-receive systems, and third and fourth control terminals for controlling the receiving circuits of the first and second transmit-receive systems. The receiving circuits of the first and second transmit-receive systems may be controlled by the same control terminal.

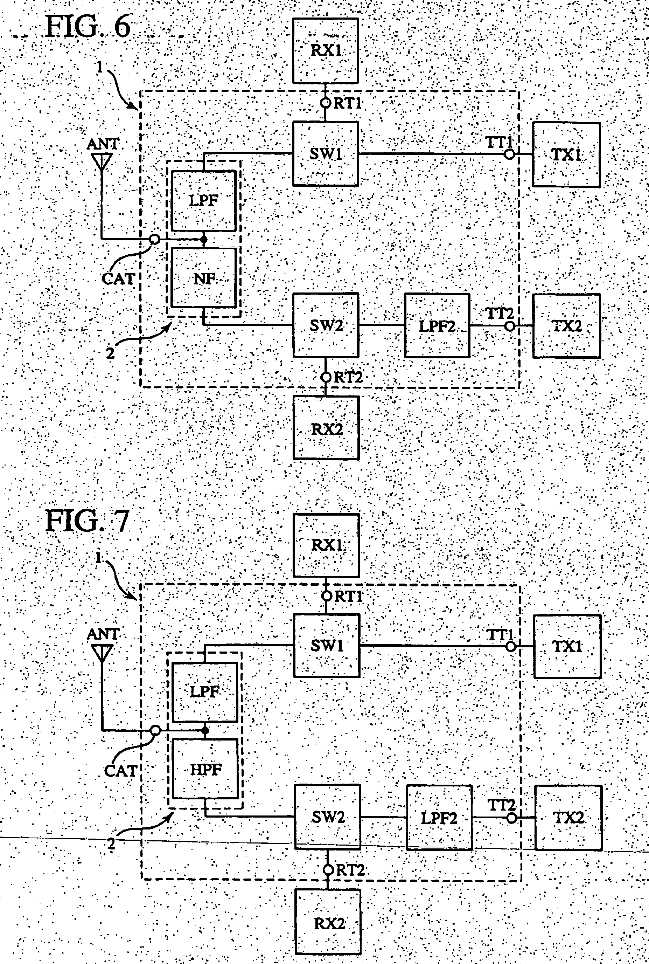

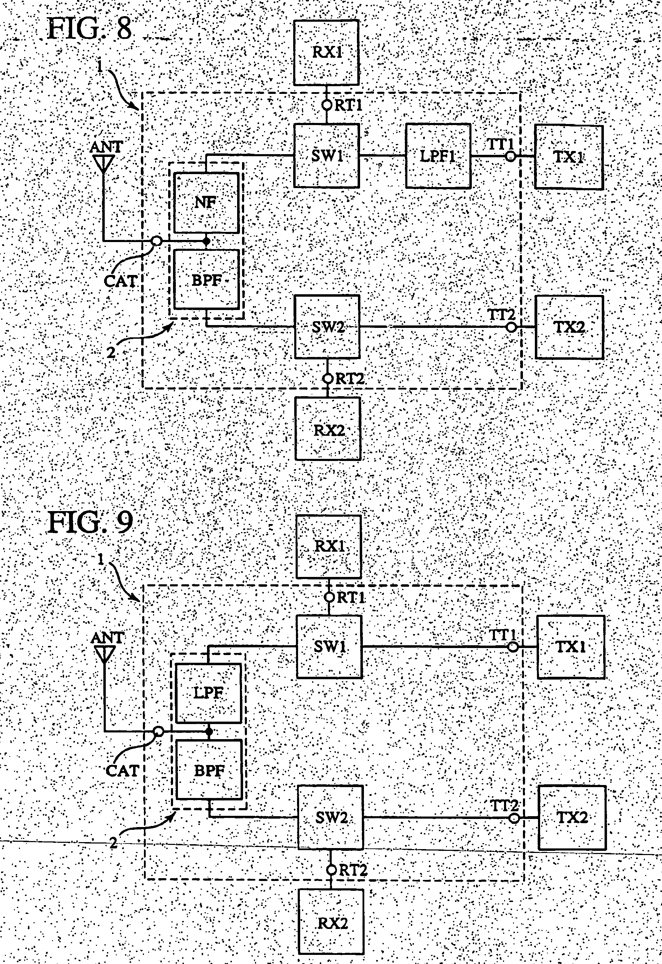

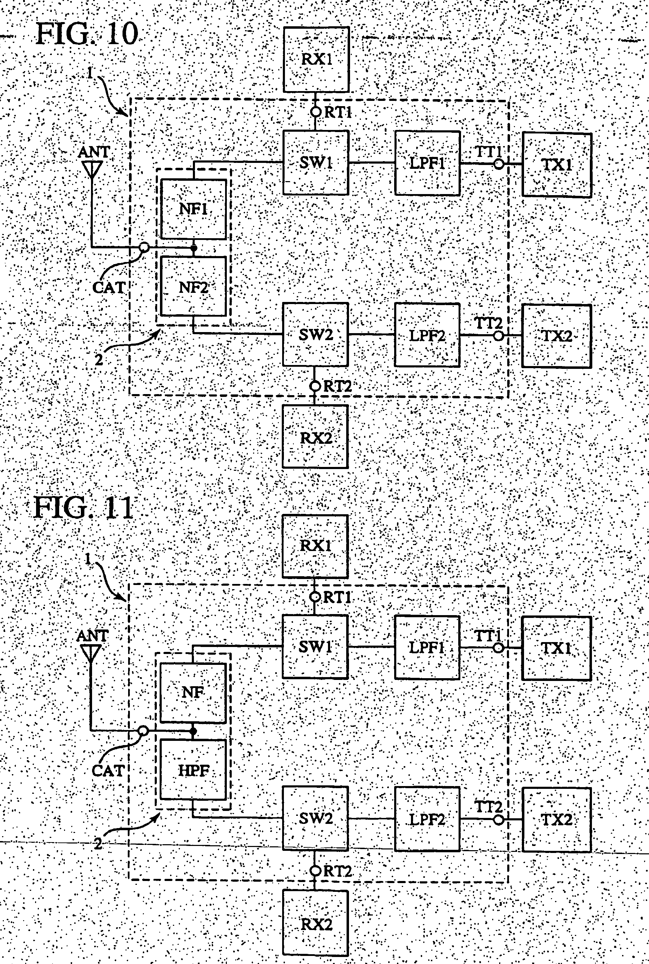

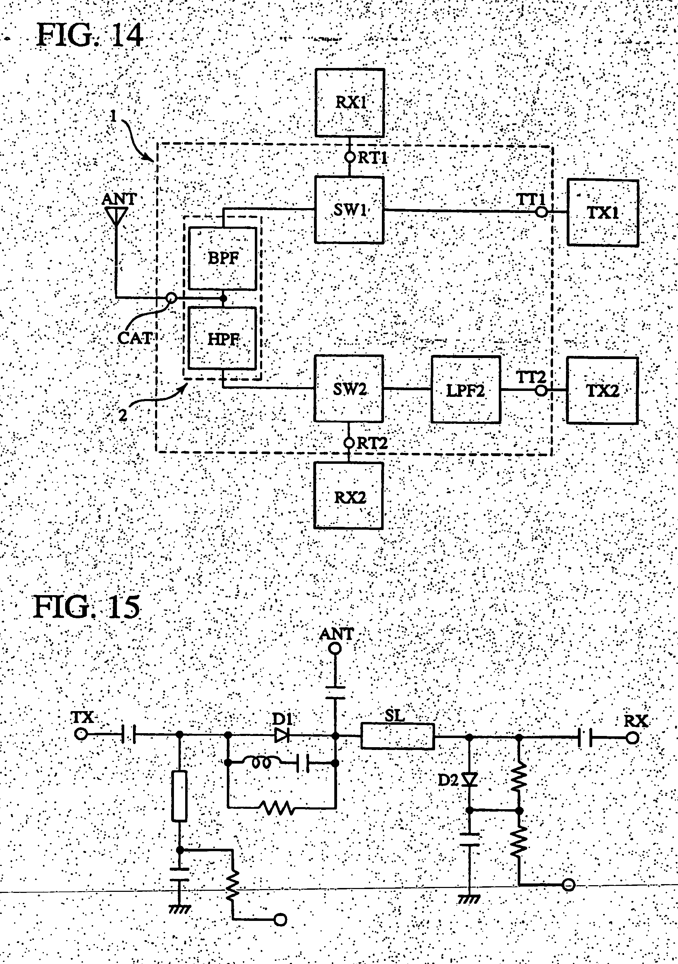

A low-pass filter circuit comprising an inductor component and a capacitor component may be incorporated into the switching circuit to provide the transmit system (a path from the common antenna terminal to the transmit terminal through the band-separating circuit and the switching circuit) of each transmit-receive system with a low-pass filtering function. Thus, the multiband high-frequency switching module of the present invention may include the following various circuit constructions.
(A) As shown in Fig. 6, in a first preferred circuit, the band-separating circuit 2 is constituted by a low-pass filter circuit LPF for the first transmit-receive system and a notch filter circuit NF for the second transmit-receive system, and a low-pass filter circuit LPF2 is incorporated into the second switching circuit SW2.
(B) As shown in Fig. 7, in a second preferred circuit, the band-separating circuit 2 is constituted by a low-pass filter circuit LPF for the first transmit-receive system and a high-pass filter circuit HPF for the second transmit-receive system, and a low-pass filter circuit LPF2 is incorporated into the second switching circuit SW2.
(C) As shown in Fig. 8, in a third preferred circuit, the band-separating circuit 2 is constituted by a notch filter circuit NF for the first transmit-receive system and a band-pass filter circuit BPF for the second transmit-receive system, and a low-pass filter circuit LPF1 is incorporated into the first switching circuit SW1.
(D) As shown in Fig. 9, in a fourth preferred circuit, the band-separating circuit 2 is constituted by a low-pass filter circuit LPF for the first transmit-receive system and a band-pass filter circuit BPF for the second transmit-receive system. No low-pass filter circuit is incorporated into the switching circuits, because the band-pass filter circuit BPF has a function of low-pass filter.
(E) As shown in Fig. 10, in a fifth preferred circuit, the band-separating circuit 2 is constituted by a first notch filter circuit NF1 for the first transmit-receive system and a second notch filter circuit NF2 for the second transmit-receive system. A first low-pass filter circuit LPF 1 and a second low-pass filter circuit LPF2 are respectively incorporated into the first switching circuit SW1 and the second switching circuit SW2.
(F) As shown in Fig. 11, in a sixth preferred circuit, the band-separating circuit 2 is constituted by a notch filter circuit NF for the first transmit-receive system and a high-pass filter circuit HPF for the second transmit-receive system. A first low-pass filter circuit LPF1 and a second low-pass filter circuit LPF2 are respectively incorporated into the first switching circuit SW1 and the second switching circuit SW2.
(G) As shown in Fig. 13, in a seventh preferred circuit, the band-separating circuit 2 is constituted by a band-pass filter circuit BPF for the first transmit-receive system and a notch filter circuit NF for the second transmit-receive system, and a low-pass filter circuit LPF2 is incorporated into the second switching circuit SW2.
(H) As shown in Fig. 14, in an eighth preferred circuit, the band-separating circuit 2 is constituted by a band-pass filter circuit BPF for the first transmit-receive system and a high-pass filter circuit HPF for the second transmit-receive system, and a low-pass filter circuit LPF2 is incorporated into the second switching circuit SW2.

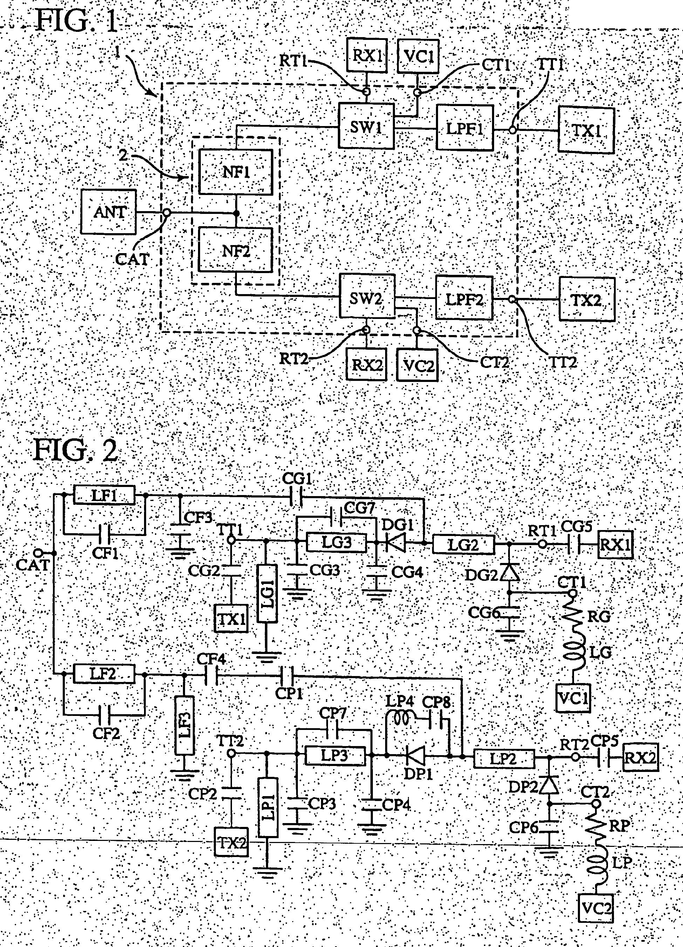

Fig. 1 is a block schematic diagram showing a preferred embodiment of the multiband high-frequency switching module according to the present invention. The multiband high-frequency switching module 1 surrounded by broken line is used in a communication system utilising two transmit-receive systems having different passbands, and suitable for alternately connecting a common antenna ANT to a transmitting circuit (TX1, TX2) and a receiving circuit (RX1, RX2) of each transmit-receive system in a dual-band radiotelephone. For example, a first transmit-receive system may be (Global System for Mobile Communication (GSM) and a second transmit-receive system may be Digital Cellular System (DCS)1800 system.

The multiband high-frequency switching module 1 of Fig. 1 comprises a first switching circuit SW1 for switching a transmitting circuit TX1 and a receiving circuit RX1 of the first transmit-receive system (GSM), a first low-pass filter circuit LPF1 incorporated into the first switching circuit SW1, a first transmit terminal TT1 for connecting the transmitting circuit TX1, a second switching circuit SW2 for switching a transmitting circuit TX2 and a receiving circuit RX2 of the second transmit-receive system (DCS), a second low-pass filter circuit LPF2 incorporated into the second switching circuit SW2, a second transmit terminal TT2 for connecting the transmitting circuit TX2, and a band-separating circuit 2 for separating the bands of communication signals to the respective transmit-receive systems. The switching circuits SW1, SW2 may have control terminals CT1, CT2 for respectively connecting control circuits VC1, VC2. The band-separating circuit comprises first and second notch filter circuits NF1, NF2, one end of each notch filter circuit being connected to a common antenna terminal CAT for connecting a common antenna ANT, and the other end thereof being connected to respective switching circuit. The receiving circuits RX1, RX2 are respectively connected to the switching circuits SW1, SW2 through receive terminals RT1, RT2.

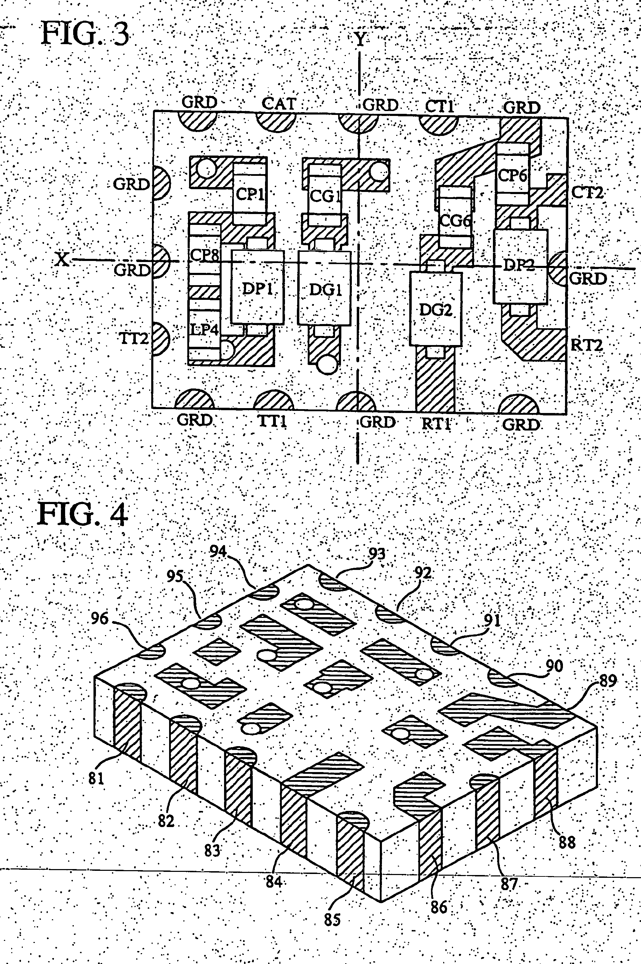

Fig. 2 is a schematic circuit diagram showing an equivalent circuit of the multiband high-frequency switching module of Fig. 1. The band-separating circuit connected to the common antenna terminal CAT includes first and second notch circuits, the first notch circuit comprising parallel-connected inductor LF1 and capacitor CF1 and the second notch circuit comprising parallel-connected inductor LF2 and capacitor CF2. One of the ends of the first notch circuit is connected to the common antenna terminal CAT and the opposite end is grounded through a capacitor CF3 for enhancing the low-pass filtering operation of the band-separating circuit. One of the ends of the second notch circuit is connected to the common antenna terminal CAT and the opposite end is connected to a capacitor CF4 and an inductor LF3 being grounded. The inductor LF3 and the capacitor CF4 enhance the high-pass filtering operation of the band-separating circuit.

The first switching circuit SW1 comprises diodes DG1, DG2 and transmission lines LG1, LG2. The anode of the diode DG1 is connected to the common antenna terminal CAT through a capacitor CG1. The anode is further connected, through the transmission line LG2, to a receive terminal RT1 for connecting the receiving circuit RX1 through a capacitor CG5. The cathode of the diode DG2 is connected between the transmission line LG2 and the receive terminal RT1, and the anode is grounded through a capacitor CG6. Between the diode DG2 and the capacitor CG6, the control terminal CT1 for connecting the control circuit VC1 through series-connected resistor RG and inductor LG is connected in a shunt configuration. The cathode of the diode DG1 is connected, through a low-pass filter circuit LPF1, to a transmit terminal TT1 for connecting the transmitting circuit TX1 through a capacitor CG2. The low-pass filter circuit LPF1 comprises an inductor LG3 and capacitors CG3, CG4, CG7. Between the low-pass filter circuit LPF1 and the transmit terminal TT1, the transmission line LG1 being grounded is connected in a shunt configuration.

The second switching circuit SW2 comprises diodes DP1, DP2 and transmission lines LP1, LP2. The anode of the diode DP1 is connected to the common antenna terminal CAT through a capacitor CP1 which may be omitted. The anode is further connected, through a transmission line LP2, to a receive terminal RT2 for connecting the receiving circuit RX2 through a capacitor CP5. The cathode of the diode DP2 is connected between the transmission line LP2 and the receive terminal RT2, and the anode is grounded through a capacitor CP6. Between the anode and the capacitor CP6, a control terminal CT2 for connecting the control circuit VC2 through series-connected resistor RP and inductor LP is connected in a shunt configuration. The cathode of the diode DP1 is connected, through a low-pass filter circuit LPF2, to a transmit terminal TT2 for connecting the transmitting circuit TX2 through a capacitor CP2. The low-pass filter circuit LPF2 comprises an inductor LP3 and capacitors CP3, CP4, CP7. Between the low-pass filter circuit LPF2 and the transmit terminal TT2, the transmission line LP1 being grounded is connected in a shunt configuration. Series-connected inductor LP4 and capacitor 8 is connected to the diode DP1 in parallel. This LC series circuit is optional, and improves the isolation characteristics when the diode DP1 is in off-state.

The multiband high-frequency switching module of the above circuit is made into a form of laminate body comprising a plurality of dielectric substrates, pattern electrodes formed on the dielectric substrates, terminal electrodes made on the side surfaces of the laminate body, and circuit elements mounted to the top surface of the laminate body.

In the present invention, the common antenna terminal to which a plurality of transmit-receive systems are connected through the band-separating circuit, the transmit terminals for connecting the transmitting circuit of respective transmit-receive systems, and the receive terminals for connecting the receiving circuits of respective transmit-receive systems are made on the side surfaces of the laminate body, thereby enabling to mount the multiband high-frequency switching module to a circuit board through the bottom surface thereof. Each terminal may extend to the top or bottom surface.

On each of the four side surfaces, at least one ground terminal is preferably formed to reduce the insertion loss of the multiband high-frequency switching module. At least one ground terminal or control terminal for controlling the switching circuit, preferably the ground terminal, is disposed between the high-frequency terminals (the common antenna terminal, the transmit terminals and the receive terminals) on the side surface to prevent the high-frequency terminals from being positioned directly adjacent to each other. With such a configuration, the interference between the high-frequency terminals is minimised and the insertion loss is reduced. Also, the isolation between the signal terminals is made good.

In a more preferred embodiment, each of the high-frequency terminals is disposed between two ground terminals. With this configuration, the leakage of signals and the interference between the high-frequency terminals are more securely avoided and the isolation between the high-frequency terminals are enhanced.

The transmit terminals are preferred to be collectively positioned while being separated by the intervening ground terminal or control terminal as mentioned above. The receive terminals are also preferred to be collectively positioned. The transmit terminals and the receive terminals are preferably disposed on the opposite sides with respect to a vertical plane, perpendicular to the side surface having the common antenna terminal, dividing the laminate body into two equal parts. More preferably, the transmit terminals and the receive terminals are located symmetrically with respect to the vertical plane. Such a construction makes it easy to respectively connect the transmit terminals and the receive terminals to the respective transmitting circuits and the receiving circuits on the circuit board to which the multiband high-frequency switching module is to be mounted.

In addition, the common antenna terminal and the other high-frequency terminals (the transmit terminals and receive terminals) are preferably disposed on the opposite sides with respect to another vertical plane, preferably perpendicular to the above vertical plane and parallel to the side surface having the common antenna terminal, dividing the laminate body into two equal parts. Since the multiband high-frequency switching module is disposed between the common antenna and the transmitting and receiving circuits, with such a configuration, the multiband high-frequency switching module can be connected to the common antenna and the transmitting and receiving circuits by the shortest lines, thereby to avoid an additional insertion loss.

As described above, it is preferable that the common antenna terminal is disposed on one of the two parts formed by dividing the laminate body with a first vertical plane parallel to the side surface having the common antenna terminal, and the transmit and receive terminals on the other. Assuming that the other half opposite to the common antenna terminal is further equally divided into two quadrisect parts by a second vertical plane perpendicular to the first plane, it is preferable that the transmit terminals is disposed on one of the quadrisect parts and the receive terminals on the other. In this configuration, the transmit terminals are collectively disposed on one quadrisect part and the receive terminals are collectively disposed on the other. Therefore, as described above, the connection of the multiband high-frequency switching module to the common antenna, the transmitting circuits and the receiving circuits is made by a short line to avoid an additional insertion loss.

In the laminate body, the circuit of the multiband high-frequency switching module is formed by the pattern electrodes formed on the dielectric substrates and the chip elements mounted on the top surface of the laminate body.

The band-separating circuit and the transmission lines of the switching circuits are preferably formed by the pattern electrodes on the inner substrates between the top substrate and the bottom substrate. More specifically, the transmission lines of the switching circuits are preferably formed by the pattern electrodes on the substrates between the substrates having the ground electrode patterns. The pattern electrodes for the band-separating circuit comprising a capacitor component and an inductor component are formed on the substrates laminated on the substrate having the upper ground electrode pattern. The pattern electrode for the inductor component is formed on the substrate being laminated above the substrate having the pattern electrode for the capacitor component.

In the present invention, it is preferable that the transmit system of at least one transmit-receive system has a low-pass filtering function. This can be achieved by constituting the band-separating circuit from at least one low-pass filter circuit as described above. Another method is to incorporate a low-pass filter circuit into at least one switching circuit. For example, as shown in Fig. 2, the low-pass filter circuit LPF1 comprising the inductor LG3 and the capacitors CG3, CG4, CG7 is incorporated into the first switching circuit SW1, namely between the diode DG1 and the transmission line LG1 each constituting the first switching circuit SW1. Such an incorporation of the low-pass filter circuit into the switching circuit makes the overall circuit symmetrical, thereby to reduce the insertion loss and secure high characteristics in broad band. The pattern electrodes for the low-pass filter circuit to be incorporated into the switching circuit is preferably formed on the substrates to be laminated above the substrates having the pattern electrodes for the switching circuits. Specifically, the pattern electrodes for the capacitor component of the low-pass filter circuit are formed on the substrates above the substrate having the upper ground pattern electrode, and the pattern electrode for the inductor component is formed on the substrate being laminated above the substrates having the capacitor pattern electrodes.

The pattern electrodes for the inductor components and the pattern electrodes for the capacitor components are preferably formed on the different substrates. The capacitor pattern electrodes of the low-pass filter circuit being incorporated into the switching circuit and the capacitor pattern electrodes of the band-separating circuit are preferred to be formed on the same substrate separately. Also, the inductor pattern electrodes of the low-pass filter circuit and the band-separating circuit are preferably formed on the same substrate separately. The band-separating circuit and the low-pass filter circuit may be connected to the switching circuit via through holes made on the substrates intervening therebetween.

As described above, the laminate body of the present invention preferably comprises, from the bottom surface (mounting surface), the substrate having the lower ground electrode, the substrates having the transmission lines of the switching circuits, the substrate having the upper ground electrode, the substrates having the capacitor components of the band-separating circuit and the low-pass filter circuit, and the substrates having the inductor components of the band-separating circuit and the low-pass filter circuit.

On the top surface of the laminate body, chip elements of the diodes and the capacitors other than those constituting the band-separating circuit, the switching circuits and the low-pass filter circuits are mounted. A metal cover for covering the chip elements may be disposed on the top surface of the laminate body while maintaining the terminal electrodes on the side surfaces exposed to the atmosphere. The metal cover may be fixed to the laminate body by soldering or a mounting device.

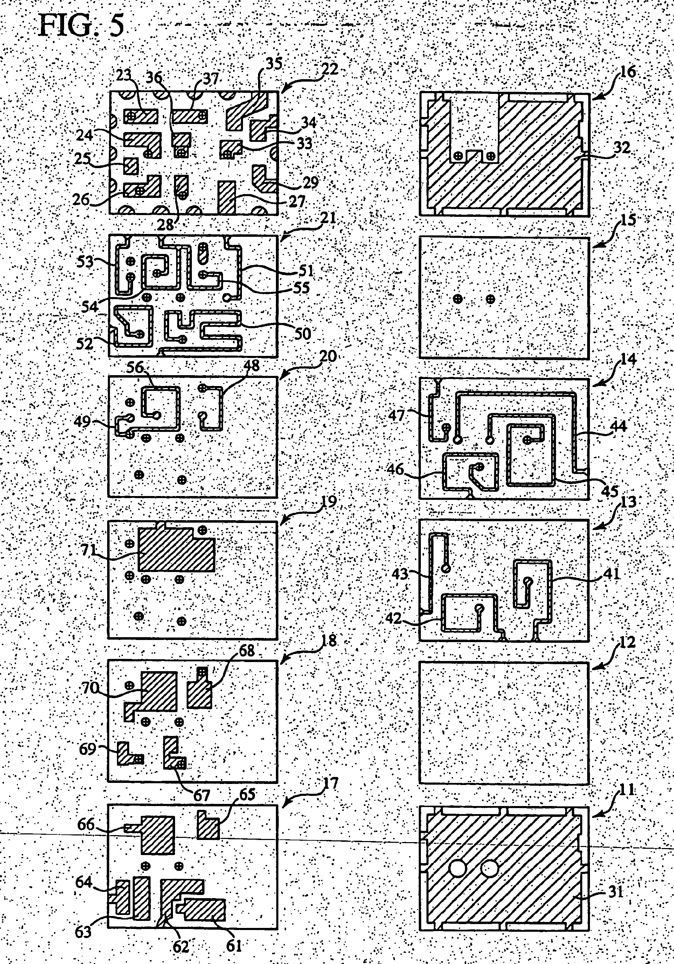

A plan view and a perspective view of a laminate body of the multiband high-frequency switching module having the equivalent circuit of Fig. 2 are shown in Fig. 3 and Fig. 4, respectively. Fig. 5 is a plan view showing each substrate constructing the laminate body of Figs. 3 and 4. In this embodiment, the band-separating circuit, the low-pass filter circuits and the transmission lines of the switching circuits were formed on the inner substrates of the laminate body. On the top surface of the laminate body, the diodes and chip capacitors were mounted.

The laminate body was produced as described below. A green sheet made of a dielectric ceramic material sinterable at low temperatures was used as the substrate. The pattern electrodes for each circuit elements were formed by printing an electrically conductive paste mainly comprising Ag on the green sheets. The green sheets with pattern electrodes and, if desired, a green sheet with no pattern electrode (dummy layer) were stacked and sintered to produce the integral laminate body.

As best shown in Fig. 5, green sheets 11 to 22 were stacked in turn with the green sheet 11 disposed lowermost and with the green sheet 22 disposed uppermost. A ground electrode 31 was formed on nearly entire surface of the lowermost green sheet 11. The ground electrode 31 had ports for connecting the ground terminals (GRD) 81, 83, 85, 87, 89, 91, 93, 94 and 95 to be formed on the side surfaces of the resultant laminate body. On the lowermost green sheet 11, stacked was the dummy green sheet 12 with no pattern electrode.

On the green sheet 13, line electrodes 41, 42, 43 were printed. On the green sheet 14, line electrodes 44 to 47 were formed. Each of the line electrodes 45-47 had at one end thereof a through hole electrode shown by a circle with a cross. The green sheet 15 had only two through hole electrodes. The green sheet 16 having a ground electrode 32 was stacked on the green sheet 15. The line electrodes disposed between the ground electrodes 31 and 32 constitute the transmission lines of the first and second switching circuits, SW1, SW2. Specifically, the line electrodes 42 and 46 are connected to each other by the through hole electrode to constitute the transmission line LG1. Likewise, the line electrodes 41 and 45 constitute the transmission line LG2, and the line electrodes 43 and 47 constitute the transmission line LP1. The line electrode 44 constitutes the transmission line LP2.

On the green sheets 17 to 19, printed were the pattern electrodes 67 to 71 for constituting capacitors. The pattern electrodes 61 to 65 respectively constitute the capacitors CG4, CG3, CP4, CP3 and CF3, each with the ground electrode 32. Further, the electrodes 66 and 70, the electrodes 64 and 69, the electrodes 62 and 67, the electrodes 70 and 71 and the electrodes 68 and 71 respectively constitute the capacitors CF4, CP7, CG7, CF2 and CF1. The ground electrode 32 is partly cut out so that the electrode 66 opposes only to the electrode 70. In the cut out portion of the ground electrode 32, formed were two through hole electrodes communicated to the line electrodes 44 and 45.

On the green sheet 19, the green sheet 20 having line electrodes 48, 49, 56 was disposed. Line electrodes 50 to 55 were formed on the green sheet 21. On the uppermost green sheet 22, were formed lands 23 to 29 and 33 to 37 for connecting the chip elements, such as diodes and chip capacitors, being mounted thereon. The line electrodes 48 and 55 were connected to each other via the through hole electrode to constitute LF1. Likewise, the line electrodes 54 and 56 constitute LF2, and the line electrodes 49 and 53 constitute LF3. The line electrodes 50 and 52 respectively constitute LG3 and LP3. The line electrode 51 is a DC line for the control circuit.

The above green sheets 11 to 22 were stacked, pressed and then sintered in a known manner to obtain an integral laminate body. On the side surfaces of the laminate body, the terminal electrodes 81 to 96 were formed as shown in Fig. 4. Then, diodes DG1, DG2, DP1, DP2, chip capacitors CG1, CG6, CP1, CP6, CP8, and a chip inductor LP4 were mounted to the respective lands on the top surface of the laminate body to obtain a multiband high-frequency switching module of the present invention in the form of laminate body.

Of the circuit elements shown in Fig. 2, CP2, CP5, CG2, CG5, RG, LG, RP and LP are formed on the circuit board to which the multiband high-frequency switching module is mounted.

In the above embodiment, the transmission lines 41 to 47 of the first and second switching circuits are disposed between the ground electrodes 31, 32 to effectively prevent the interference between the switching circuits and the band-separating circuit and/or the low-pass filter circuits. Since the ground electrodes are disposed lower in the laminate body, the grounding is easily secured. The capacitors CG3, CG4, CP3, CP4, CF3 being grounded are formed by opposing the upper ground electrode 32 to the pattern electrodes 61 to 65 on the substrate just above the upper ground electrode 32.

Also, since the terminal electrodes are formed on the side surface of the laminate body, the multiband high-frequency switching module can be mounted through its bottom surface. The high-frequency terminals (common antenna terminal CAT, transmit terminals TT1, TT2, receive terminals RT1, RT2) are located separately by the intervening ground terminal GRD and control terminal CT1, CT2. At least one ground terminal is disposed between the high-frequency terminals. In other words, any one of the high-frequency terminals is disposed between the ground electrodes. Further, at least one ground terminal is disposed on any of the side surfaces of the laminate body.

As shown in Fig. 3, the common antenna terminal CAT and the other high-frequency terminals (transmit terminals TT1, TT2 and receive terminals RT1, RT2) are located on opposite sides with respect to a vertical plane X parallel to the side surface having the common antenna terminal CAT and dividing the laminate body into two equal parts. Also, the transmit terminals TT1, TT2 and the receive terminals RT1, RT2 are located on opposite sides with respect to another vertical plane Y, perpendicular to the plane X, dividing the laminate body into equal two parts.

As described above, the multiband high-frequency switching module of the present invention alternately connects the common antenna to the transmitting or receiving circuit of a first transmit-receive system or the transmitting or receiving circuit of a second transmit-receive system. The first and second transmit-receive systems may be GSM system and DCS1800 system. However, the present invention is not limited to the above embodiment, and equally applicable to switching the transmitting circuits and the receiving circuits of a plurality of transmit-receive systems having different passbands.

The multiband high-frequency switching module of the present invention is suitable for use in a dual-band cellular radiotelephone, etc. Since the multiband high-frequency switching module can be made into a small chip with laminated structure, the present invention is effective for reducing the size of the dual-band cellular radiotelephone, etc.

## Claims

1. A multiband high-frequency switching module in the form of a laminate body for use in a communication system utilising a plurality of transmit-receive systems having different passbands, a circuit of said switching module comprising:
a band-separating circuit (2) having one end connected to a common antenna terminal (CAT) for connection to a common antenna, said band-separating circuit being constituted by filter circuits each comprising an LC circuit; and
switching circuits (SW1, SW2) for said plurality of transmit-receive systems, one end of each switching circuit being connected to said band-separating circuit (2) and the other end being connected in parallel to a receive terminal (RT1, RT2) for connection to a receiving circuit (RX1, RX2) and a transmit terminal (TT1, TT2) for connection to a transmitting circuit (TX1, TX2) so as to alternately connect said common antenna to said receiving circuit or said transmitting circuit;
wherein said laminate body comprise a plurality of dielectric layers, pattern electrodes printed on said dielectric layers, terminal electrodes formed on surfaces of said laminate body, and chip elements mounted on a top surface of said laminate body;
wherein said LC circuits of said band-separating circuit (2) is formed in said laminate body by pattern electrodes (48, 55; 56, 54; 49, 53; 71, 68, 70, 65, 66);
wherein a transmit system comprising said common antenna terminal (CAT), said band-separating circuit (2), said switching circuit (SW1, SW2) and said transmit terminal (TT1, TT2) of at least one transmit-receive system has a low-pass filtering function provided by a low-pass filter circuit (LPF1, LPF2) comprising an LC circuit formed in said laminate body by pattern electrodes (50, 52, 61, 62, 63, 64, 67, 69),
wherein inductor pattern electrodes (50, 52, 53, 54, 55) of said low-pass filter circuit (LPF1, LPF2) and band-separating circuit (2) are formed on the same surface (21) of at least one of said dielectric layer, and/or capacitor pattern electrodes (67, 69, 68, 70) of said low-pass filter circuit and band-separating circuit are formed on the same surface (18) of at least one of said dielectric layers, and
wherein pattern electrodes (48, 55; 54, 56, 49, 53; 71, 68, 70, 65, 66) for said band-separating circuit (2) and pattern electrodes (50, 52, 61, 62, 63, 64, 67, 69) for said low-pass filter circuit (LPF1, LPF2) are separated in the horizontal direction of said laminate body.

2. The switching module of claim 1, wherein said switching circuits (SW1, SW2) comprises transmission lines (LG1, LG2; LP1, LP2) and switch elements (DG1, DG2; DP1, DP2), and wherein pattern electrodes (45, 44) of at least said transmission lines (LG2, LP2) connected to said receiving circuits (RX1, RX2) for said plurality of switching circuits (SW1, SW2) are formed on at least one same surface of layers of said laminate body.

3. The switching module of claim 1 or 2, wherein said switching circuits (SW1, SW2) comprise transmission lines (LG1, LG2; LP1, LP2) and switch elements (DG1, DG2; DP1, DP2), and wherein pattern electrodes (41, 45; 44) of at least said transmission lines (LG2, LP2) connected to said receiving circuits (RX1. RX2) for said plurality of switching circuits (SW1, SW2) are disposed on layers (13, 14) between a layer (16) having an upper ground electrode (32) and a layer having a lower ground electrode (31).

4. The switching module of claim 3, wherein through hole electrodes are formed in the layer (16) having one of said upper and lower ground electrodes (32, 31), and said pattern electrodes (45, 44) of said transmission lines (LG2, LP2) connected to said receiving circuit (RX1, RX2) are connected to said switch elements (DG1, DP1) mounted on said laminate body via said through hole electrodes.

5. The switching module of claim 4, wherein said pattern electrodes (45, 44) of said transmission lines (LG2, LP2) connected to said receiving circuit (RX1, RX2) are connected to said band separating circuit (2) formed on inner layers of said laminate body via said through hole electrodes.

6. The switching module of any preceding claim, wherein a capacitor (CF3) being grounded is connected between the first filter circuit (NF1) of said band-separating circuit (2) and the first switching circuit (SW1) in a shunt configuration.

7. The switching module of claim 6, wherein a pattern electrode (65) to form a capacitor (CF3) in a shunt configuration is formed in said laminate body, and said pattern electrode (65) to form said capacitor (CF3) in a shunt configuration is disposed in a position opposite to one of said upper and lower ground electrodes (32, 31).

8. The switching module of any preceding claim, wherein a capacitor (CF4) is connected between the second filter circuit (NF2) of said band-separating circuit (2) and the second switching circuit (SW2), and an inductor (LF3) being connected to a line to be grounded is connected between said second filter circuit (NF2) and said capacitor (CF4).

9. The switching module of any preceding claim, wherein pattern electrodes (48, 55, 54, 56; 49, 53; 50, 52) for inductors (LF1, LF2; LF3; LG3, LP3) and pattern electrodes (71, 68, 70, 66, 65, 62, 61, 67, 64, 63, 69) for capacitors (CF1, CF2, CF4; CF3; CG3; CG4; CG7; CP3; CP4, CP7) are printed on different layers (17, 18, 19, 20, 21).

10. The switching module of any preceding claim, wherein said common antenna terminal (CAT), said receive terminals (RT1, RT2) and said transmit terminals (TT1, TT2) are formed on side surfaces of said laminate body, and wherein at least one ground terminal (GRD) is formed on each of said side surfaces.

11. The switching module of any preceding claim, wherein said switching circuit (SW1, SW2) of each transmit-receive system (GSM, DCS) is further connected to a control terminal (CT1, CT2) for connecting a control circuit (VC1, VC2), and wherein at least one terminal selected from the group consisting of ground terminals (GRD) and said control terminals (CT1, CT2) is disposed between any adjacent high-frequency terminals selected from the group consisting of said common antenna terminal (CAT), said transmit terminals (TT1, TT2) and said receive terminals (RT1, RT2).

12. The switching module of any preceding claim, wherein layers having pattern electrodes (42, 46; 41, 45; 43, 47; 44) for transmission lines (LG1, LG2, LP1, LP2) of said switching circuits (SW1, SW2), layers having pattern electrodes (61, 62, 63, 64, 65, 66; 67, 68, 69, 70; 71) for capacitors (CG4; CG3, CP4, CP3, CF3, CF4; CG7; CF1, CP7, CF4, CF2; CF1) and layers having pattern electrodes (48, 55; 54, 56; 49, 53; 50; 52) for inductors (LF1, LF2; LF3; LG3, LP3) are disposed in this order from a mounting surface of said laminate body.

13. The switching module of any preceding claim, wherein said switching circuit (SW1, SW2) of each transmit-receive system (GSM, DCS) is provided with switch elements (DG1, DG2; DP1, DP2) for switching said transmitting circuit (TX1, TX2) and said receiving circuit (RX1, RX2), each of said switch elements (DG2, DP2) having a control terminal (CT1, CT2) for controlling a transmit system of each transmit-receive system (GSM, DCS) and a common control terminal for controlling respective receive systems of said plurality of transmit-receive systems, and the switching operation of said switch elements (DG1, DG2; DP1, DP2) being controlled by respectively applying a predetermined level of voltage to said control terminal (CT1, CT2) and said common control terminal.

14. The switching module of any preceding claim, wherein said low-pass filtering function is provided by a low-pass filter circuit (LPF1, LPF2) incorporated into said switching circuit (SW1, SW2).

15. The switching module of any preceding claim, wherein a metal case is disposed on said top surface of said laminate body so as to cover said chip elements.

16. A mobile phone utilising the multi-band high-frequency switching module of any preceding claim.

## Patentansprüche

1. Mehrfachband-HF-Schaltmodul in Form eines Schichtkörpers zur Verwendung in einem mit mehreren Empfangs/Sende-Systemen unterschiedlicher Durchlassbänder arbeitenden Nachrichtensystem, wobei eine Schaltung des Schaltmoduls aufweist:
eine Bandtrennstufe (2), deren eines Ende mit einem gemeinsamen Antennenanschluss (CAT) zum Anschluss an eine gemeinsame Antenne verbunden ist, wobei die Bandtrennstufe aus jeweils einen LC-Kreis enthaltenden Filterstufen aufgebaut ist, und
Schaltstufen (SW1, SW2) für die mehreren Empfangs/Sende-Systeme, wobei ein Ende jeder Schaltstufe an die Bandtrennstufe (2) angeschlossen ist und das andere Ende parallel zu einem Empfangsanschluss (RT1, RT2) zum Anschluss an einen Empfangskreis (RX1, RX2) und einem Sendeanschluss (TT1, TT2) zum Anschluss an einen Sendekreis (TX1, TX2) liegt, um die gemeinsame Antenne abwechselnd mit dem Empfangskreis oder dem Sendekreis zu verbinden,
wobei der Schichtkörper mehrere dielektrische Schichten, auf diese aufgedruckte Musterelektroden, auf Flächen des Schichtkörpers ausgebildete Anschlusselektroden und auf einer oberen Fläche des Schichtkörpers angebrachte Chipelemente aufweist,
wobei die LC-Kreise der Bandtrennstufe (2) in dem Schichtkörper von Musterelektroden (48, 55; 56, 54; 49, 53; 71, 68, 70, 65, 66) gebildet sind,
wobei ein den gemeinsamen Antennenanschluss (CAT), die Bandtrennstufe (2), die Schaltstufe (SW1, SW2) und den Sendeanschluss (TT1, TT2) umfassendes Sendesystem mindestens eines Sende/Empfangs-Systems eine Tiefpass-Filterfunktion aufweist, die von einer Tiefpass-Filterstufe (LPF1, LPF2) mit einem von Musterelektroden (50, 52, 61, 62, 63, 64, 67, 69) in dem Schichtkörper gebildeten LC-Kreis erzeugt wird,
wobei Induktivitäts-Musterelektroden (50, 52, 53, 54, 55) der Tiefpass-Filterstufe (LPF1, LPF2) und der Bandtrennstufe (2) auf derselben Fläche (21) mindestens einer der dielektrischen Schichten und/oder Kapaitäts-Musterelektroden (67, 69, 68, 70) der Tiefpass-Filterstufe und der Bandtrennstufe auf derselben Fläche (18) mindestens einer der dielektrischen Schichten ausgebildet sind, und
wobei Musterelektroden (48, 55; 54, 56, 49, 53; 71, 68, 70, 65, 66) für die Bandtrennstufe (2) und Musterelektroden (50, 52, 61, 62, 63, 64, 67, 69) für die Tiefpass-Filterstufe (LPF1, LPF2) in Horizontalrichtung des Schichtkörpers getrennt sind.

2. Schaltmodul nach Anspruch 1, wobei die Schaltstufen (SW1, SW2) Übertragungsleitungen (LG1, LG2; LP1, LP2) und Schaltelemente (DG1, DG2; DP1, DP2) umfassen und Musterelektroden (45, 44) mindestens der an die Empfangskreise (RX1, RX2) für die mehreren Schaltstufen (SW1, SW2) angeschlossenen Übertragungsleitungen (LG2, LP2) auf mindestens einer Fläche von Schichten des Schichtkörpers gemeinsam ausgebildet sind.

3. Schaltmodul nach Anspruch 1 oder 2, wobei die Schaltstufen (SW1, SW2) Übertragungsleitungen (LG1, LG2; LP1, LP2) und Schaltelemente (DG1, DG2; DP1, DP2) umfassen und Musterelektroden (41, 45; 44) mindestens der an die Empfangskreise (RX1, RX2) für die mehreren Schaltstufen (SW1, SW2) angeschlossenen Übertragungsleitungen (LG2, LP2) auf Schichten (13, 14) zwischen einer Schicht (16) mit einer oberen Masseelektrode (32) und einer Schicht mit einer unteren Masseelektrode (31) angeordnet sind.

4. Schaltmodul nach Anspruch 3, wobei in der Schicht (16) mit der oberen oder der unteren Masseelektrode (32, 31) Durchgangslochelektroden ausgebildet sind, über die Musterelektroden (45, 44) der an den Empfangskreis (RX1, RX2) angeschlossenen Übertragungsleitungen (LG2, LP2) mit den auf dem Schichtkörper angebrachten Schaltelementen (DG1, DP1) verbunden sind.

5. Schaltmodul nach Anspruch 4, wobei die Musterelektroden (45, 44) der an den Empfangskreis (RX1, RX2) angeschlossenen Übertragungsleitungen (LG2, LP2) über die Durchgangslochelektroden mit der auf inneren Schichten des Schichtkörpers ausgebildeten Bandtrennstufe (2) verbunden sind.

6. Schaltmodul nach einem der vorhergehenden Ansprüche, wobei zwischen der ersten Filterstufe (NF1) der Bandtrennstufe (2) und der ersten Schaltstufe (SW1) ein an Masse liegender Kondensator (CF3) im Nebenschluss liegt.

7. Schaltmodul nach Anspruch 6, wobei in dem Schichtkörper eine einen Nebenschluss-Kondensator (CF3) bildende Musterelektrode (65) ausgebildet ist, die an einer der oberen oder der unteren Masseelektrode (32, 31) gegenüberliegenden Stelle angeordnet ist.

8. Schaltmodul nach einem der vorhergehenden Ansprüche, wobei zwischen der zweiten Filterstufe (NF2) der Bandtrennstufe (2) und der zweiten Schaltstufe (SW2) ein Kondensator (CF4) und zwischen der zweiten Filterstufe (NF2) und dem Kondensator (CF4) eine an eine Masseleitung anzuschließende Induktivität (LF3) liegt.

9. Schaltmodul nach einem der vorhergehenden Ansprüche, wobei Musterelektroden (48, 55, 54, 56; 49, 53; 50, 52) für Induktivitäten (LF1, LF2; LF3; LG3, LP3) und Musterelektroden (71, 68, 70, 66, 65, 62, 61, 67, 64, 63, 69) für Kondensatoren (CF1, CF2, CF4; CF3; CG3; CG4; CG7; CP3; CP4, CP7) auf verschiedene Schichten (17, 18, 19, 20, 21) aufgedruckt sind.

10. Schaltmodul nach einem der vorhergehenden Ansprüche, wobei der gemeinsame Antennenanschluss (CAT), die Empfangsanschlüsse (RT1, RT2) und die Sendeanschlüsse (TT1, TT2) auf Seitenflächen des Schichtkörpers und mindestens ein Masseanschluss (GRD) auf jeder der Seitenflächen ausgebildet ist.

11. Schaltmodul nach einem der vorhergehenden Ansprüche, wobei die Schaltstufe (SW1, SW2) jedes Sende/Empfangs-Systems (GSM, DCS) außerdem mit einem Steueranschluss (CT1, CT2) zum Anschluss einer Steuerschaltung (VC1, VC2) verbunden ist und mindestens einer der Masseanschlüsse (GRD) oder der Steueranschlüsse (CT1, CT2) zwischen benachbarten HF-Anschlüssen liegt, zu denen der gemeinsame Antennenanschluss (CAT), die Sendeanschlüsse (TT1, TT2) und die Empfangsanschlüsse (RT1, RT2) gehören.

12. Schaltmodul nach einem der vorhergehenden Ansprüche, wobei Schichten mit Musterelektroden (42, 46; 41, 45; 43, 47; 44) für Übertragungsleitungen (LG1, LG2, LP1, LP2) der Schaltstufen (SW1, SW2), Schichten mit Musterelektroden (61, 62, 63, 64, 65, 66; 67, 68, 69, 70; 71) für Kondensatoren (CG4; CG3, CP4, CP3, CF3, CF4; CG7; CF1, CP7, CF4, CF2; CF1) und Schichten mit Musterelektroden (48, 55; 54, 56; 49, 53; 50; 52) für Induktivitäten (LF1, LF2; LF3; LG3, LP3) in dieser Reihenfolge von einer Aufbaufläche des Schichtkörpers ausgehend angeordnet sind.

13. Schaltmodul nach einem der vorhergehenden Ansprüche, wobei die Schaltstufe (SW1, SW2) jedes Sende/Empfangs-Systems (GSM, DCS) mit Schaltelementen (DG1, DG2; DP1, DP2) zum Schalten des Sendekreises (TX1, TX2) und des Empfangskreises (RX1, RX2) versehen ist, wobei jedes der Schaltelemente (DG2, DP2) einen Steueranschluss (CT1, CT2) zum Ansteuern eines Sendesystems jedes Sende/Empfangs-Systems (GSM, DCS) und einen gemeinsamen Steueranschluss zum Ansteuern jeweiliger Empfangssysteme der mehreren Empfangs/Sende-Systeme aufweist, und wobei der Schaltvorgang der Schaltelemente (DG1, DG2; DP1, DP2) durch Anlegen eines vorbestimmten Spannungspegels an den Steueranschluss (CT1, CT2) und den gemeinsamen Steueranschluss gesteuert wird.

14. Schaltmodul nach einem der vorhergehenden Ansprüche, wobei die Tiefpass-Filterfunktion von einer in die Schaltstufe (SW1, SW2) eingebauten Tiefpass-Filterstufe (LPF1, LPF2) erzeugt wird.

15. Schaltmodul nach einem der vorhergehenden Ansprüche, wobei auf der oberen Fläche des Schichtkörpers ein die Chipelemente abdeckendes Metallgehäuse angeordnet ist.

16. Mobiltelefon mit dem Mehrfachband-HF-Schaltmodul nach einem der vorhergehenden Ansprüche.

## Revendications

1. Module de commutation multibande à haute fréquence sous la forme d'un corps laminé destiné à être utilisé dans un système de communication utilisant une pluralité de systèmes d'émission-réception ayant différentes bandes passantes, un circuit dudit module de commutation comprenant :
un circuit de séparation de bande (2) ayant une extrémité reliée à une borne d'antenne commune (CAT) pour connexion à une antenne commune, ledit circuit de séparation de bande étant constitué par des circuits de filtre comprenant chacun un circuit LC ; et
des circuits de commutation (SW1, SW2) pour ladite pluralité de systèmes d'émission-réception, une extrémité de chaque circuit de commutation étant connectée audit circuit de séparation de bande (2) et l'autre extrémité étant connectée à la fois à une borne de réception (RT1, RT2) pour connexion à un circuit de réception (RX1, RX2) et à une borne d'émission (TT1, TT2) pour connexion à un circuit d'émission (TX1, TX2) de manière à connecter alternativement ladite antenne commune audit circuit de réception ou audit circuit d'émission ;
dans lequel ledit corps laminé comprend une pluralité de couches diélectriques, des électrodes à motif imprimées sur lesdites couches diélectriques, des électrodes de borne formées sur des surface dudit corps laminé, et des éléments de puce montés sur une surface supérieure dudit corps laminé ;
dans lequel ledit circuit LC dudit circuit de séparation de bande (2) est formé dans le corps laminé au moyen d'électrodes à motif (48, 55 ; 56,54 ; 49, 53 ; 71, 60, 68, 70, 65, 66) ;
dans lequel un système d'émission comprenant ladite borne d'antenne commune (CAT), ledit circuit de séparation de bande (2), ledit circuit de commutation (SW1,SW2) et ladite borne d'émission (TT1, TT2) d'au moins un système d'émission-réception, possède une fonction de filtrage passe-bas fournie par un circuit de filtre passe-bas (LPF1, LPF2) comprenant un circuit LC formé dans ledit corps laminé au moyen d'électrodes à motif (50, 52, 61-64, 67, 69),
dans lequel des électrodes inductives à motif (50, 52, 53, 54, 55) dudit circuit de filtre passe-bas (LPF1, LPF2) et dudit circuit de séparation de bande (2) sont formées sur une même surface (21) de l'une au moins desdites couches diélectriques, et/ou des électrodes à motif capacitives (67-70) dudit circuit de filtre passe-bas et dudit circuit de séparation de bande (2) sont formées sur une même surface (18) de l'une au moins desdites couches diélectriques, et
dans lequel des électrodes à motif (48, 55 ; 54, 56, 49, 53 ; 71, 68, 70, 65, 66) pour ledit circuit de séparation de bande (2) et des électrodes à motif (50, 52, 61, 62, 63, 64, 67, 69) pour ledit circuit de filtre passe-bas (LPF1, LPF2) sont séparées selon la direction horizontale dudit corps laminé.

2. Module de commutation selon la revendication 1, dans lequel lesdits circuits de commutation (SW1, SW2) comprennent des lignes de transmission (LG1, LG2 ; LP1, LP2) et des éléments de commutation (DG1, DG2 ; DP1, DP2), et dans lequel les électrodes à motif (45, 44) de l'une au moins des lignes de transmission (LG2, LP2) connectées auxdits circuits de réception (RX1, RX2) pour ladite pluralité de circuits de commutation (SW1, SW2), sont formées sur au moins une même surface des couches dudit corps laminé.

3. Module selon la revendication 1 ou 2, dans lequel lesdits circuits de commutation (SW1, SW2) comprennent des lignes de transmission (LG1, LG2 ; LP1, LP2) et des éléments de commutation (DG1, DG2 ; DP1, DP2) et dans lequel des électrodes à motif (41, 45 ; 44) d'au moins lesdites lignes de transmission (LG2, LP2) connectées auxdits circuits de réception (RX1, RX2) pour ladite pluralité de circuits de commutation (SW1, SW2), sont agencées sur des couches (13, 14) entre une couche (16) ayant une électrode de masse supérieure et une couche ayant une électrode de masse inférieure (31).

4. Module de commutation selon la revendication 3, dans lequel des électrodes à trou traversant sont formées dans la couche (16) ayant l'une desdites électrodes de masse supérieure et inférieure (32, 31), et lesdites électrodes à motif (45, 44) desdites lignes de transmission (LG2, LP2) connectées audit circuit de réception (RX1, RX2) sont connectés auxdits éléments de commutation (DG1, DP1) montés sur ledit corps laminé grâce auxdites électrodes à trou traversant.

5. Module de commutation selon la revendication 4, dans lequel lesdites électrodes à motif (45, 44) desdites lignes de transmission (LG2, LP2) connectées audit circuit de réception (RX1, RX2) sont connectées audit circuit de séparation de bande (2), formé sur des couches intérieures dudit corps laminé, grâce auxdites électrodes à trou traversant.

6. Module de commutation selon l'une des revendications précédentes, dans lequel une capacité (CF3) mise à la masse est montée en dérivation entre le premier circuit de filtre (NF1) dudit circuit de séparation de bande (2) et le premier circuit de commutation (SW1).

7. Module de commutation selon la revendication 6, dans lequel une électrode à motif (65), destinée à réaliser une capacité (CF3) montée en dérivation, est formée dans ledit corps laminé, et ladite électrode à motif (65) destinée à réaliser ladite capacité (CF3) montée en dérivation est agencée en un emplacement opposé à celui de l'une desdites électrodes de masse supérieure et inférieure (32, 31).

8. Module de commutation selon l'une des revendications précédentes, dans lequel une capacité (CF4) est connectée entre le second circuit de filtre (NF2) dudit circuit de séparation de bande (2) et ledit second circuit de commutation (SW2), et une induction (LF3) reliée à une ligne mise à la masse est connectée entre ledit second circuit de filtre (NF2) et ladite capacité (CF4).

9. Module de commutation selon l'une des revendications précédentes, dans lequel des électrodes à motif (48, 55, 54, 56 ; 49, 53 ; 50, 52) pour des inductions (LF1, LF2 ; LP3 ; LG3, LP3) et des électrodes à motif (71, 68, 70, 66, 65, 62, 61, 67, 64, 63, 69) pour des capacités (CF1, CF2, CF4 ; CF3 ; CG3 ; CG4 ; CG7 ; CP3 ; CP4, CP7) sont imprimées sur différentes couches (17-21).

10. Module de commutation selon l'une des revendications précédentes, dans lequel ladite borne d'antenne commune (CAT), lesdites bornes de réception (RT1, RT2) et lesdites bornes d'émission (TT1, TT2) sont formées sur des surfaces latérales dudit corps laminé, et dans lequel au moins une borne de masse (GRD) est formée sur chacune desdites surfaces latérales.

11. Module de commutation selon l'une des revendications précédentes, dans lequel ledit circuit de commutation (SW1, SW2) de chaque système d'émission-réception (GSM, DCS) est en outre connecté à une borne de commande (CT1, CT2) pour connecter un circuit de commande (VC1, VC2), et dans lequel au moins une borne sélectionnée parmi l'ensemble constitué des bornes de masse (GRD) et desdites bornes de commande (CT1, CT2) est agencée entre n'importe laquelle des bornes à haute fréquence adjacentes sélectionnées parmi l'ensemble constitué de la borne d'antenne commune (CAT), desdites bornes d'émission (TT1, TT2) et desdites bornes de réception (RT1, RT2).

12. Module de commutation selon l'une des revendications précédentes, dans lequel des couches ayant les électrodes à motif (41-47) pour des lignes de transmission (LG1, LG2, LP1, LP2) desdits circuits de commutation (SW1, SW2), des couches ayant des électrodes à motif (61-71) pour des condensateurs (CF1-CF4, CG3, CG4, CG7, CP3, CP4, CP7), et des couches ayant des électrodes à motif (48-50,52-56) pour des inductions (LF1-LF3, LG3, LP3) sont agencées dans cet ordre, en partant d'une surface de montage dudit corps laminé.

13. Module selon l'une quelconque des revendications précédentes, dans lequel ledit circuit de commutation (SW1, SW2) de chaque système d'émission-réception (GSM, DCS) est pourvu d'éléments commutateur (DG1, DG2, DP1, DP2) pour commuter ledit circuit de transmission (TX1, TX2) et ledit circuit de réception (RX1, RX2), chacun desdits éléments commutateur (DG2, DP2) ayant une borne de commande (CT1, CT2) pour commander les systèmes de réception respectifs desdits systèmes d'émission-réception (GSM, DCS), l'opération de commutation desdits éléments commutateur (DG1, DG2, DP1, DP2) étant commandée en appliquant respectivement un niveau de tension prédéterminé à ladite borne de commande (CT1, CT2) et à ladite borne de commande commune.

14. Module selon l'une quelconque des revendications précédentes, dans lequel ladite fonction de filtrage passe-bas est fournie par un circuit de filtre passe-bas (LPF1, LPF2) incorporé dans ledit circuit de commutation (SW1, SW2).

15. Module selon l'une quelconque des revendications précédentes, dans lequel un boîtier métallique est disposé sur la surface supérieure dudit corps laminé de façon à recouvrir lesdits éléments de puce.

16. Téléphone mobile utilisant le module de commutation multibande à haute fréquence selon l'une quelconque des revendications précédentes.
